(19) Europäisches Patentamt
European Patent Office
Office européen des brevets

(11) **EP 4 311 718 A1**

(12) **EUROPEAN PATENT APPLICATION**

(43) Date of publication:
**31.01.2024 Bulletin 2024/05**

(21) Application number: **23186995.9**

(22) Date of filing: **21.07.2023**

(51) International Patent Classification (IPC):
**B60L 58/16** (2019.01)   **G01R 31/382** (2019.01)
**G01R 31/392** (2019.01)

(52) Cooperative Patent Classification (CPC):
**B60L 58/16; B60L 3/12; B60L 58/12; G01R 31/382;**
**G01R 31/392;** B60L 2240/80; B60L 2260/44;
B60L 2260/46; B60L 2260/50; B60L 2260/54;
Y02T 10/70

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **27.07.2022   CN 202210890148**

(71) Applicants:
• **ZHEJIANG ZEEKR INTELLIGENT TECHNOLOGY**
  **CO., LTD.**
  **315000 Ningbo Zhejiang (CN)**
• **Viridi E-Mobility Technology (Ningbo) Co., Ltd**
  **315000 Ningbo Zhejiang (CN)**
• **Zhejiang Geely Holding Group Co., Ltd.**
  **Hangzhou, Zhejiang 310000 (CN)**

(72) Inventors:
• **ZHANG, Ruitian**
  **Ningbo, 315000 (CN)**

• **WANG, Huan**
  **Ningbo, 315000 (CN)**
• **ZHANG, Zhenglei**
  **Ningbo, 315000 (CN)**
• **SUN, Zhe**
  **Ningbo, 315000 (CN)**
• **DENG, Ziwei**
  **Ningbo, 315000 (CN)**
• **NIU, Shangbing**
  **Ningbo, 315000 (CN)**
• **WANG, Qi**
  **Ningbo, 315000 (CN)**
• **NIU, Yaqi**
  **Ningbo, 315000 (CN)**

(74) Representative: **Monteiro Alves, Inês**
**Alameda Dos Oceanos, № 41K-21**
**Parque das Nações**
**1990-207 Lisboa (PT)**

(54) **METHOD AND A DEVICE FOR PREDICTING STATE OF HEALTH OF BATTERY, ELECTRONIC EQUIPMENT AND READABLE STORAGE MEDIUM**

(57)   Disclosed are a method and a device for predicting state of health of a battery, an electronic equipment and a readable storage medium. The method includes: (S10), obtaining battery data of a vehicle; (S20), performing feature extraction on the battery data to obtain a vehicle-using behavior feature corresponding to the vehicle; (S30), predicting and obtaining a predicted vehicle-using behavior feature of the vehicle in a next time step according to the vehicle-using behavior feature; and (S40), predicting and obtaining a health degree of the battery in the vehicle according to the predicted vehicle-using behavior feature and a battery health state prediction model.

## Description

## TECHNICAL FIELD

The present application relates to the technical field of electric vehicles, and in particular to a method and a device for predicting state of health of a battery, an electronic equipment and a readable storage medium.

## BACKGROUND

With the rapid development of electric vehicles, lithium batteries are widely used in electric vehicles due to their high voltage, high specific energy and long cycle life. In order to prolong the service life of electric vehicles, ensure the safe operation of electric vehicles and improve user experience, the battery state needs to be evaluated to optimize and adjust the energy management strategy of electric vehicles, and the battery state can usually be determined by calculating the state of health (SOH) of the battery.

Nowadays, in the related art, the method for calculating the SOH of the battery to determine the state of the battery usually predicts the SOH through the external feature parameters of the battery and the neural network model to obtain the SOH of the battery. However, this method only predicts based on the feature of the battery itself, and does not take into account other factors such as the user's driving behavior and user's vehicle-using habits, so the accuracy for predicting the SOH of the battery is low.

## SUMMARY

The main objective of the present application is to provide a method and a device for predicting state of health (SOH) of a battery, an electronic equipment and a readable storage medium, aiming to solve the technical problem of low prediction accuracy of the battery health state in the related art.

In order to achieve the above objective, the present application provides a method for predicting state of health of a battery, applied to a device for predicting SOH of a battery, including:

obtaining battery data of a vehicle;
performing feature extraction on the battery data to obtain a vehicle-using behavior feature corresponding to the vehicle;
predicting and obtaining a predicted vehicle-using behavior feature of the vehicle in a next time step according to the vehicle-using behavior feature; and
predicting and obtaining a health degree of the battery in the vehicle according to the predicted vehicle-using behavior feature and a battery health state prediction model.

In an embodiment, a feature type of the vehicle-using behavior feature includes a proportion feature and an accumulation feature, and the predicting and obtaining the predicted vehicle-using behavior feature of the vehicle in the next time step according to the vehicle-using behavior feature includes:

predicting and obtaining a predicted accumulation feature of the vehicle in the next time step according to a preset linear fitting model and the vehicle-using behavior feature; and
aggregating the proportion feature and the accumulation feature to obtain the predicted vehicle-using behavior feature of the vehicle in the next time step.

In an embodiment, before the predicting and obtaining the health degree of the battery in the vehicle according to the predicted vehicle-using behavior feature and the battery health state prediction model, the method further includes:

obtaining a battery health state prediction model to be trained and training sample data of the battery in the vehicle, and calculating a real health degree of the battery based on the training sample data;
performing feature extraction on the training sample data to obtain a training vehicle-using behavior feature corresponding to the battery;
performing normalization processing on the training vehicle-using behavior feature to obtain normalized vehicle-using behavior feature;
predicting and obtaining a training health degree of the battery according to the normalized vehicle-using behavior feature and the battery health state prediction model to be trained; and
iteratively optimizing the battery health state prediction model to be trained to obtain the battery health state prediction model according to the training health degree and the real health degree.

In an embodiment, a feature content of the training vehicle-using behavior feature includes a user behavior feature and a battery performance feature, and the performing the feature extraction on the training sample data to obtain the training vehicle-using behavior feature corresponding to the battery includes:

obtaining a cut-off time of battery charging data for calculating the real health degree in the training battery data;
selecting training battery data satisfying a preset health state prediction condition before the cut-off time from the training sample data; and
extracting the user behavior feature and the battery performance feature according to the training battery data.

In an embodiment, the calculating the real health degree of the battery based on the training sample data includes:

selecting battery charging data satisfying a preset charging working condition from the training sample data, wherein the battery charging data includes a training battery current of the battery during a charging process, a first remaining power of the training battery to start the charging process, a second remaining power of the training battery after the charging process and a rated battery capacity of the battery; and
determining the real health degree of the battery according to the training battery current, the first remaining power, the second remaining power and the rated battery capacity.

In an embodiment, the selecting the battery charging data satisfying the preset charging working condition from the training sample data includes:

selecting a first battery data from the training sample data, wherein the first battery data is battery data whose resting duration after the charging process is completed is longer than a preset duration threshold; and
determining that a second battery data in the first battery data is the battery charging data, wherein the second battery data is battery data in which a difference between the second remaining power and the first remaining power is greater than a preset power threshold and a current at the end of the charging process is less than a preset current threshold.

In an embodiment, the performing the normalization processing on the training vehicle-using behavior feature to obtain the normalized vehicle-using behavior feature includes:

obtaining a preset feature threshold corresponding to each training vehicle-using behavior feature; and
obtaining the normalized vehicle-using behavior feature according to a ratio of each training vehicle-using behavior feature to the preset feature threshold.

In order to achieve the above objective, the present application further provides a device for predicting state of health of a battery, including:

an obtaining module for obtaining battery data of a vehicle;
an extraction module for performing feature extraction on the battery data to obtain a vehicle-using behavior feature corresponding to the vehicle;
a feature predicting module for predicting and obtaining a predicted vehicle-using behavior feature of the vehicle in a next time step according to the vehicle-using behavior feature; and
a health degree predicting module for predicting and obtaining a health degree of the battery in the vehicle according to the predicted vehicle-using behavior feature and a battery health state prediction model.

In an embodiment, a feature type of the vehicle-using behavior feature includes a proportion feature and an accumulation feature, and the feature predicting module is further configured for predicting and obtaining a predicted accumulation feature of the vehicle in the next time step according to a preset linear fitting model and the vehicle-using behavior feature; and aggregating the proportion feature and the accumulation feature to obtain the predicted vehicle-using behavior feature of the vehicle in the next time step.

In an embodiment, before the predicting and obtaining the health degree of the battery in the vehicle according to the predicted vehicle-using behavior feature and the battery health state prediction model, the device is further configured for:

obtaining a battery health state prediction model to be trained and training sample data of the battery in the vehicle, and calculating a real health degree of the battery based on the training sample data;
performing feature extraction on the training sample data to obtain a training vehicle-using behavior feature corresponding to the battery;
performing normalization processing on the training vehicle-using behavior feature to obtain normalized vehicle-using behavior feature;
predicting and obtaining a training health degree of the battery according to the normalized vehicle-using behavior feature and the battery health state prediction model to be trained; and
iteratively optimizing the battery health state prediction model to be trained to obtain the battery health state prediction model according to the training health degree and the real health degree.

In an embodiment, a feature content of the training vehicle-using behavior feature includes a user behavior feature and a battery performance feature, and the device for predicting the state of health of the battery is further configured for:

obtaining a cut-off time of battery charging data for calculating the real health degree in the training battery data;
selecting training battery data satisfying a preset health state prediction condition before the cut-off time from the training sample data; and
extracting the user behavior feature and the battery performance feature according to the training battery data.

In an embodiment, the device for predicting the state of health of the battery is further configured for:

selecting battery charging data satisfying a preset charging working condition from the training sample data, wherein the battery charging data includes a training battery current of the battery during a charging process, a first remaining power of the training battery to start the charging process, a second remaining power of the training battery after the charging process and a rated battery capacity of the battery; and

determining the real health degree of the battery according to the training battery current, the first remaining power, the second remaining power and the rated battery capacity.

In an embodiment, the device for predicting the state of health of the battery is further configured for:

selecting a first battery data from the training sample data, wherein the first battery data is battery data whose resting duration after the charging process is completed is longer than a preset duration threshold; and

determining that a second battery data in the first battery data is the battery charging data, wherein the second battery data is battery data in which a difference between the second remaining power and the first remaining power is greater than a preset power threshold and a current at the end of the charging process is less than a preset current threshold.

In an embodiment, the device for predicting the state of health of the battery is further configured for:

obtaining a preset feature threshold corresponding to each training vehicle-using behavior feature; and obtaining the normalized vehicle-using behavior feature according to a ratio of each training vehicle-using behavior feature to the preset feature threshold.

The present application further provides an electronic equipment, including: at least one processor; and a memory communicated with the at least one processor, the memory stores instructions executable by the at least one processor, and when the instructions are executed by the at least one processor, the at least one processor performs the method for predicting the state of health of the battery as described above.

The present application further provides a computer-readable storage medium, the computer-readable storage medium stores a program for realizing a method for predicting state of health of a battery, and when the program for realizing the method for predicting the state of health of the battery is executed by a processor, the processor performs the method for predicting the state of health of the battery as described above.

The present application provides a method for predicting state of health of a battery, an electronic equipment and a readable storage medium. The method includes: obtaining battery data of a vehicle; performing feature extraction on the battery data to obtain a vehicle-using behavior feature corresponding to the vehicle; predicting and obtaining a predicted vehicle-using behavior feature of the vehicle in a next time step according to the vehicle-using behavior feature; and predicting and obtaining a health degree of the battery in the vehicle according to the predicted vehicle-using behavior feature and a battery health state prediction model.

As such, in the present application, the health degree of the battery is predicted and obtained through the vehicle-using behavior feature in the next time step extracted from the battery data and the battery health prediction model. Therefore, by integrating the properties of the battery itself in the next time step, the user's driving behavior and the battery health prediction model, the health degree of the battery is predicted, such that the predicted health degree is determined by various factors and is real-time, thereby improving the accuracy for predicting the SOH of the battery.

## BRIEF DESCRIPTION OF THE DRAWINGS

The accompanying drawings, which are incorporated in and constitute a part of this specification, illustrate embodiments consistent with the present application and together with the description serve to explain the principles of the present application.

In order to more clearly illustrate the technical solutions in the embodiments of the present application or the prior art, the following will briefly introduce the drawings that need to be used in the description of the embodiments or the prior art. Apparently, those skilled in the art can also obtain other drawings based on these drawings without any creative effort.

FIG. 1 is a schematic flowchart of a method for predicting state of health of a battery according to a first embodiment of the present application.
FIG. 2 is a graph showing the change trend of the total operating mileage of a certain vehicle over time.
FIG. 3 is a graph showing the change trend of an operating mileage prediction value and an operating mileage actual value of a certain vehicle over time.
FIG. 4 is an example diagram of the vehicle-using behavior feature and the predicted vehicle-using behavior feature of the method for predicting the state of health of the battery of the present application.
FIG. 5 is a schematic diagram of an application scenario of the method for predicting the state of health of the battery of the present application.
FIG. 6 is a schematic diagram of another application scenario of the method for predicting the state of health of the battery of the present application.
FIG. 7 is a schematic diagram of another application scenario of the method for predicting the state of health of the battery of the present application.
FIG. 8 is an example diagram of the acquisition content of total battery data of the method for predicting the state of health of the battery of the present application.

FIG. 9 is an example diagram of the acquisition content of daily battery data of the method for predicting the state of health of the battery of the present application.

FIG. 10 is an example diagram of the content of some vehicle-using behavior feature of the method for predicting the state of health of the battery of the present application.

FIG. 11 is a schematic structural diagram of the device in the hardware operating environment of the method for predicting the state of health of the battery of the present application.

FIG. 12 is a schematic structural diagram of a device for predicting state of health of a battery according to an embodiment the present application.

The realization of the objective, functional characteristics, and advantages of the present disclosure are further described with reference to the accompanying drawings.

**DETAILED DESCRIPTION OF THE EMBODIMENTS**

In order to make the above objects, features and advantages of the present application more obvious and understandable, the technical solutions in the embodiments of the present application will be clearly and completely described below in conjunction with the drawings in the embodiments of the present application. Apparently, the described embodiments are only some of the embodiments of the present application, not all of them. Based on the embodiments in the present application, all other embodiments obtained by persons of ordinary skill in the art without creative efforts shall fall within the protection scope of the present application.

Embodiments of the present application provide a method for predicting state of health (SOH) of a battery, including:

obtaining battery data of a vehicle; performing feature extraction on the battery data to obtain a vehicle-using behavior feature corresponding to the vehicle; predicting and obtaining a predicted vehicle-using behavior feature of the vehicle in a next time step according to the vehicle-using behavior feature; and predicting and obtaining a health degree of the battery in the vehicle according to the predicted vehicle-using behavior feature and a battery health state prediction model.

It should be noted that, in this embodiment, in order to prolong the service life of electric vehicles, ensure the safe operation of electric vehicles and improve user experience, the battery state needs to be evaluated to optimize and adjust the energy management strategy of electric vehicles, and the battery state can be determined by calculating the SOH of the battery. Nowadays, SOH is predicted through battery external feature parameters and neural network model to obtain battery health state. However, this method only predicts based on the feature of the battery itself, and does not take into account other factors such as the user's driving behavior and user's vehicle-using habits, so the accuracy for predicting the SOH of the battery is low.

For the above phenomenon, in the present application, the health degree of the battery is predicted and obtained through the vehicle-using behavior feature in the next time step extracted from the battery data and the battery health prediction model. Therefore, by integrating the properties of the battery itself in the next time step, the user's driving behavior and the battery health prediction model, the health degree of the battery is predicted, such that the predicted health degree is determined by various factors and is real-time, thereby improving the accuracy for predicting the SOH of the battery.

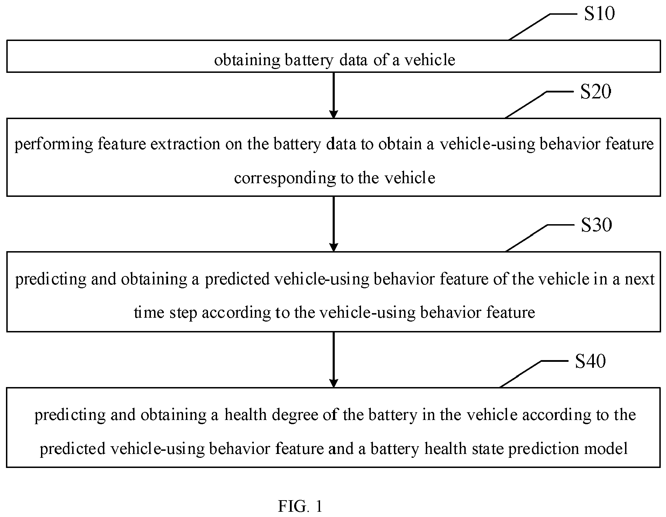

As shown in FIG. 1, in a first embodiment of the present application, a method for predicting state of health (SOH) of a battery includes the following operations.

Operation S 10, obtaining battery data of a vehicle.

It should be noted that, in this embodiment, the method for predicting the SOH of the battery can be applied to a vehicle, can also be applied to a control system in the vehicle, and can also be applied to a server communicated with the vehicle. The communication connection can be a wired connection such as an interface, or a wireless connection such as Bluetooth or a local area network, so as to realize the interactive processing of data and predict the health state of the battery in the vehicle. For the convenience of reading and understanding, the above-mentioned vehicle is used as the execution subject of the method for predicting the SOH of the battery of the present application to describe this embodiment in detail.

In this embodiment, the battery data of the vehicle is obtained.

Operation S20, performing feature extraction on the battery data to obtain a vehicle-using behavior feature corresponding to the vehicle.

In this embodiment, the vehicle uses the preset feature extractor to extract the features for characterizing the battery working state and user driving behavior in the battery data to obtain the vehicle-using behavior feature corresponding to the vehicle. The vehicle-using behavior features include but not limited to mileage features, discharge features, remaining power features, vehicle current features, vehicle speed features, vehicle operating temperature features, usage time features, charging voltage difference features and discharge voltage difference features.

Operation S30, predicting and obtaining a predicted vehicle-using behavior feature of the vehicle in a next time step according to the vehicle-using behavior feature.

A preset linear fitting model is used to map the vehicle-using behavior feature to the predicted vehicle-using behavior feature of the vehicle in the next time step.

As a feasible embodiment, in the above operation S30, a feature type of the vehicle-using behavior feature includes a proportion feature and an accumulation feature, and the predicting and obtaining the predicted vehicle-using behavior feature of the vehicle in the next time step according to the vehicle-using behavior feature includes:

Operation S31, predicting and obtaining a predicted accumulation feature of the vehicle in the next time step according to a preset linear fitting model and the vehicle-using behavior feature; and

Operation S32, aggregating the proportion feature and the accumulation feature to obtain the predicted vehicle-using behavior feature of the vehicle in the next time step.

It should be noted that, in this embodiment, the proportion feature is a feature that reflects the proportion, for example, the feature for characterizing the ratio of the parameter within the preset parameter range, and the accumulation feature is a feature that can be accumulated over time, such as the mileage and other features.

In this embodiment, the accumulation feature is mapped to the predicted accumulation feature of the vehicle in the next time step according to the preset linear fitting model. Or, the calculation result of the accumulation feature is used as the predicted accumulation feature of the vehicle in the next time step according to the preset linear fitting algorithm. Or, a time-series accumulation feature map in which the accumulation feature changes over time is constructed, and the vehicle-using behavior feature value corresponding to the vehicle in the next time step is obtained according to the time-series accumulation feature map, as the predicted vehicle-using behavior feature. The proportion feature and the accumulation feature are spliced to obtain the predicted vehicle-using behavior feature of the vehicle in the next time step.

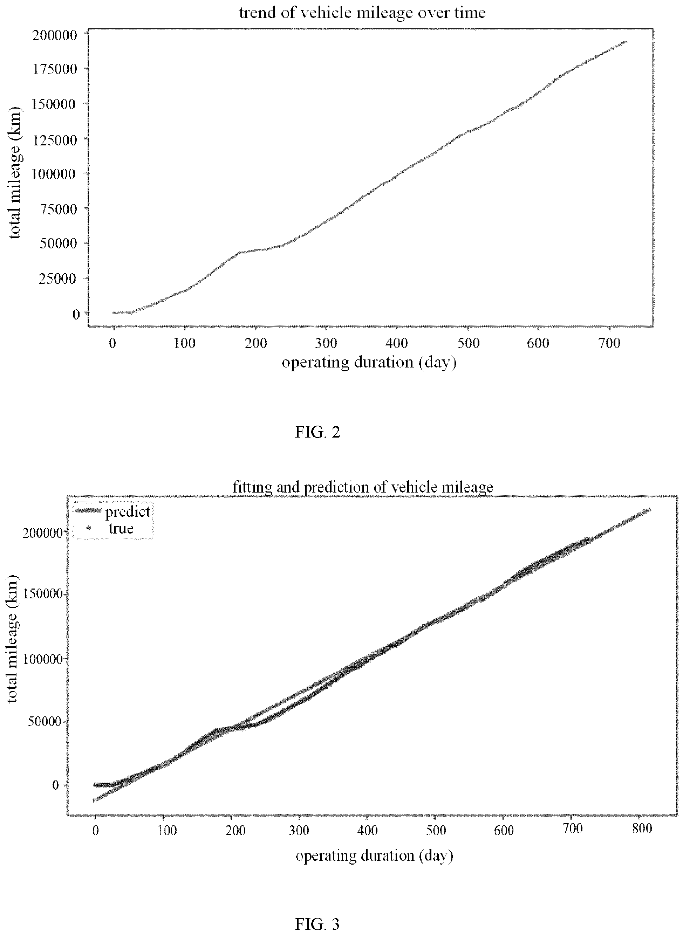

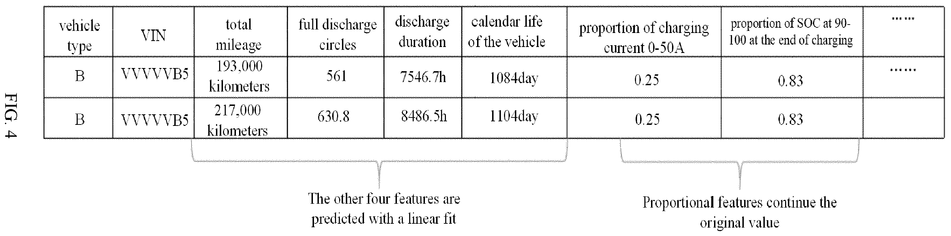

As an example, as shown in FIG. 2, FIG. 2 is a graph showing the change trend of the total operating mileage of a certain vehicle over time, and the characteristic value of the total operating mileage in the next three months is predicted by a preset linear fitting model or a preset linear fitting algorithm. As shown in FIG. 3, FIG. 3 is a graph showing the change trend of an operating mileage prediction value and an operating mileage actual value of a certain vehicle over time. As shown in FIG. 4, FIG. 4 includes the predicted vehicle-using behavior feature of a certain vehicle (the total mileage, the number of full discharge cycles, the discharge duration, the calendar life of the vehicle, the proportion of charging current 0-50A, and the proportion of SOC at 90-100 at the end of charging... shown in the figure), including the accumulation feature (the total mileage, the number of full discharge cycles, the discharge duration, and the calendar life of the vehicle shown in the figure), and the proportion feature (the proportion of charging current 0-50A and the proportion of SOC at 90-100 at the end of charging... shown in the figure). For the accumulation feature, it is predicted by linear fitting, and for the proportion feature, the original feature value is continued.

The accumulation feature is mapped to the predicted accumulation feature of the vehicle in the next time step through the preset linear fitting model, and the linear fitting of a large amount of data is achieved to obtain the predicted accumulation feature, which avoids that when the preset linear fitting algorithm is used to calculate the predicted accumulation feature of the vehicle in the next time step, the prediction accuracy of the predicted accumulation feature is low due to the limitation and low mobility of the preset linear fitting algorithm. Or, when the time-series accumulation feature map is used to obtain the vehicle-using feature value corresponding to the vehicle in the next time step as the predicted vehicle-using behavior feature, due to the small amount of data for constructing the time-series accumulation feature map, the technical defect of predicting the prediction accuracy of the accumulation feature is low, thereby improving the prediction accuracy of predicting the accumulation feature.

Operation S40, predicting and obtaining a health degree of the battery in the vehicle according to the predicted vehicle-using behavior feature and a battery health state prediction model.

In this embodiment, the predicted vehicle-using behavior feature is normalized to obtain the processed predicted vehicle-using behavior feature, and the predicted vehicle-using behavior feature is mapped to the health degree of the battery in the vehicle through the battery health state prediction model.

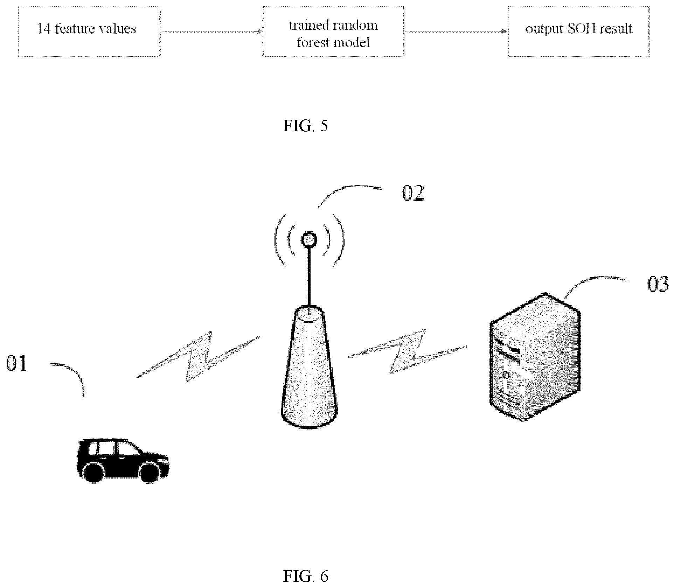

As an example, as shown in FIG. 5, FIG. 5 includes the predicted vehicle-using behavior feature (the 14 feature values shown in the figure), the battery health state prediction model (the random forest model after training shown in the figure), and the health degree of the battery in the vehicle (the output SOH result shown in the figure). The vehicle-using behavior feature is mapped to the health degree of the battery in the vehicle through the battery health state prediction model.

Since the health degree of the vehicle battery is affected by various factors, multiple features are extracted from the battery data to provide more decision-making basis for predicting the health degree of the vehicle battery and improve the prediction accuracy of the health degree of the vehicle battery. The health degree of the vehicle battery is predicted through the predicted vehicle-using behavior feature and the battery health state prediction model, which provides a real-time decision-making basis for predicting the health degree of the vehicle battery. Therefore, the prediction accuracy of the health degree of the vehicle battery is improved.

The model algorithm of the method for predicting the state of health of the battery in the above embodiments can be stored in a server communicated with the vehicle. FIG. 6 is a schematic diagram of an application scenario of the method for predicting the state of health of the battery provided in the present application. As shown in FIG. 6, the application scenario may include: a vehicle 01 equipped with a battery, and a server 03 communicating with the vehicle 01 through a communication base station 02. In FIG. 2, the vehicle 01 sends the training battery data for the server 03 to extract the vehicle-using behavior feature and the predicted vehicle-using behavior feature through the battery data. According to the predicted vehicle-using behavior feature and the battery health state prediction model, the health degree of the battery is predicted to obtain the health degree of the battery in the vehicle. The algorithm of the battery health state prediction model requires a large storage space, so in order to avoid excessive storage redundancy and operation redundancy in the vehicle control system, it is preferable to store each model in the server.

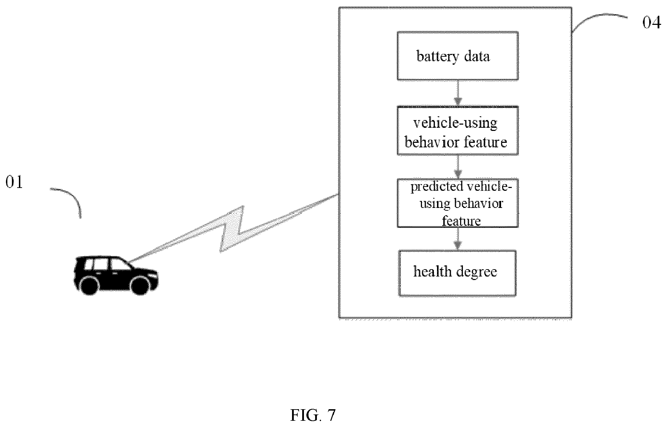

The model algorithm of the method for predicting the state of health of the battery in the above embodiments can be stored in the server communicated with the vehicle. FIG. 7 is a schematic diagram of an application scenario of the method for predicting the state of health of a battery provided by the present application. As shown in FIG. 7, the application scenario may include: a vehicle 01 equipped with a training battery, and a control process 04 of the battery health state prediction method stored in the vehicle 01. The control process 04 includes extracting the vehicle-using behavior feature according to the battery data, obtaining the predicted vehicle-using behavior feature according to the vehicle-using behavior feature, and predicting and obtaining the health degree of the battery in the vehicle according to the predicted vehicle-using behavior feature.

The present application provides a method and a device for predicting state of health of a battery, an electronic equipment and a readable storage medium. The method includes: obtaining battery data of a vehicle; performing feature extraction on the battery data to obtain a vehicle-using behavior feature corresponding to the vehicle; predicting and obtaining a predicted vehicle-using behavior feature of the vehicle in a next time step according to the vehicle-using behavior feature; and predicting and obtaining a health degree of the battery in the vehicle according to the predicted vehicle-using behavior feature and a battery health state prediction model.

As such, in the present application, the health degree of the battery is predicted and obtained through the vehicle-using behavior feature in the next time step extracted from the battery data and the battery health prediction model. Therefore, by integrating the properties of the battery itself in the next time step, the user's driving behavior and the battery health prediction model, the health degree of the battery is predicted, such that the predicted health degree is determined by various factors and is real-time, thereby improving the accuracy for predicting the SOH of the battery.

Further, based on the first embodiment, the present application provides a second embodiment of the method for predicting the state of health of the battery.

In this embodiment, the method for predicting the state of health of the battery of the present application is also implemented by the above-mentioned vehicle as the execution subject. As a feasible embodiment, in the operation S40, before the predicting and obtaining the health degree of the battery in the vehicle according to the predicted vehicle-using behavior feature and the battery health state prediction model, the method further includes:

Operation A10, obtaining a battery health state prediction model to be trained and training sample data of the battery in the vehicle, and calculating a real health degree of the battery based on the training sample data.

In this embodiment, the training sample data of the battery in the vehicle and the battery health state prediction model to be trained are obtained. Afterwards, the vehicle selects the battery charging data under ideal working conditions in the actual vehicle working conditions, calculates the health degree of the battery under ideal working conditions, and obtains the corresponding real health degree of the battery.

Operation A20, performing feature extraction on the training sample data to obtain a training vehicle-using behavior feature corresponding to the battery.

In this embodiment, the vehicle uses a preset feature extractor to extract the features for characterizing the working state of the battery and the driving behavior of the user in the training battery data, and obtain the training vehicle-using behavior feature corresponding to the training battery.

As an example, the vehicle calculates the training sample data to obtain the training driving behavior data for characterizing the working state of the battery and the user's driving behavior, uses the features corresponding to each training driving behavior data as the training vehicle-using behavior features corresponding to the battery.

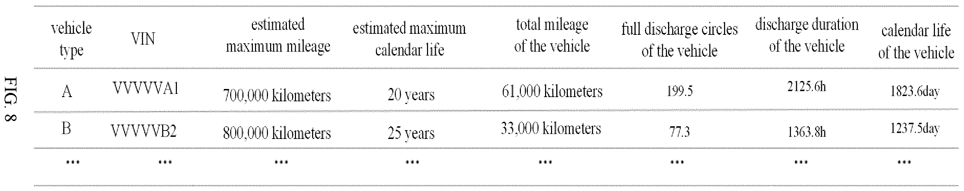

As shown in FIG. 8, FIG. 8 includes the estimated maximum mileage of the vehicle model, the expected longest calendar life of the model, the total mileage of the vehicle, the number of full discharge cycles of the vehicle, the discharge duration of the vehicle and the calendar life of the vehicle in vehicles A and B.

As a feasible embodiment, in the above operation A20, a feature content of the training vehicle-using behavior feature includes a user behavior feature and a battery performance feature, and the performing the feature extraction on the training sample data to obtain the training vehicle-using behavior feature corresponding to the battery includes:

Operation A21, obtaining a cut-off time of battery charging data for calculating the real health degree in the training battery data.

In this embodiment, the charging end time of the battery charging data satisfying the preset charging working condition is selected from the training battery data to obtain the cut-off time.

Operation A22, selecting training battery data satisfying a preset health state prediction condition before the cut-off time from the training sample data.

In this embodiment, in the training sample data, select the training battery data that is before the cut-off time and satisfies the need for the vehicle to start charging, or select the training battery data when the vehicle is not charged and the vehicle mileage is gradually increasing, that is, when the driving cycle starts.

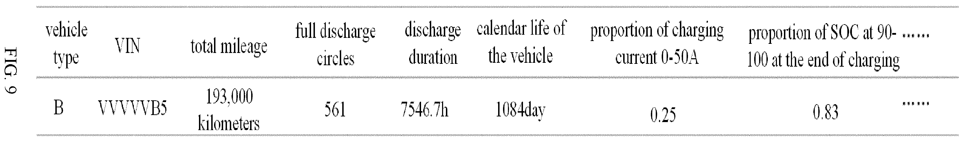

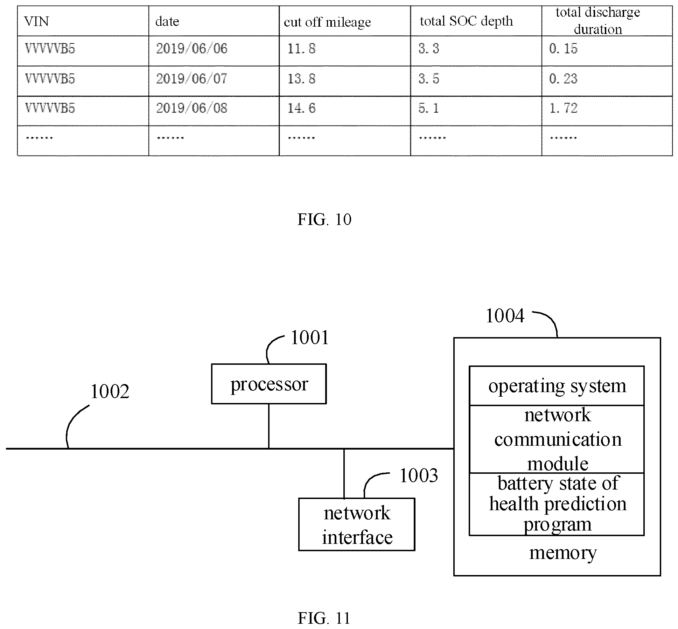

As an example, as shown in FIG. 9 and FIG. 10, FIG. 9 includes the training battery data of vehicle B before the cutoff time (the total mileage, the number of full discharge cycles, the discharge duration, the calendar life of the vehicle, the proportion of charging current 0-50A, and the proportion of SOC at the end of charging at 90-100... shown in the figure). FIG. 10 includes vehicle B's daily training battery data (the cut-off mileage, total SOC depth, and total discharge duration shown in the figure).

Operation A23, extracting the user behavior feature and the battery performance feature according to the training battery data.

It should be noted that, in this embodiment, the preset feature extractor includes a user behavior feature extraction model and a battery performance feature extraction model.

In this embodiment, the user behavior feature in the target training battery data is extracted through the user behavior feature extraction model to obtain the user behavior feature. The battery performance feature in the target training battery data is extracted through the battery performance feature extraction model to obtain the battery performance feature. The user behavior feature and the battery performance feature are spliced into the training vehicle-using behavior feature.

In an embodiment, the extracting the user behavior feature in the target training battery data through the user behavior feature extraction model to obtain the user behavior feature may include:
The user behavior feature extraction model includes the mileage feature extraction model, the discharge feature extraction model, the remaining power feature extraction model, the current feature extraction model, the vehicle speed feature extraction model and the operating temperature feature extraction model. The total mileage of the vehicle is extracted from the target training battery data through the mileage feature extraction model to obtain the mileage feature. The full discharge times and total discharge duration of the vehicle are extracted from the target training battery data through the discharge feature extraction model to obtain the discharge feature. The second remaining power at the end of the vehicle charging process is extracted from the target training battery data through the remaining power feature extraction model, which is within the first proportion of the preset charging remaining power range. For example, the preset discharge remaining power range can be 90-100, or 92-98. The third remaining power within the second proportion of the preset discharge remaining power range at the end of the vehicle discharge process is extracted to obtain the remaining power feature. For example, the range of the preset discharge remaining power can be 0-15, or 5-10. The vehicle speed feature extraction model is used to extract the third proportion of the vehicle's vehicle speed greater than the preset vehicle speed threshold in the target training battery data, to obtain the vehicle speed feature. For example, the preset vehicle speed threshold can be 120km/h or 130km/h. The minimum operating temperature of the vehicle is extracted from the target training battery data through the operating temperature feature extraction model, which is in the fourth proportion of the preset minimum operating temperature range. For example, the preset operating minimum temperature range can be -5°C to -25°C, or 0°C to -15°C. The maximum operating temperature of the vehicle is extracted from the target training battery data through the operating temperature feature extraction model to obtain the vehicle operating temperature feature, which is within the fifth proportion of the preset operating maximum temperature range. For example, the preset operating maximum temperature range may be 45°C to 50°C, or 46°C to 49°C. The charging current extracted by the current feature extraction model is within the sixth proportion of the preset charging current range. For example, the preset charging current range may be 0-50A, or 0-40A to obtain the vehicle current feature. The mileage feature, the discharge feature, the remaining power feature, the vehicle current feature, the vehicle speed feature and the vehicle operating temperature feature are spliced into the user behavior feature.

In an embodiment, the extracting the battery performance feature in the target training battery data through the battery performance feature extraction model to obtain the battery performance feature may include:
The battery performance feature extraction model includes the use time feature extraction model, the charging voltage difference feature extraction model and the discharge voltage difference feature extraction model. The time from the delivery date of the vehicle to the actual health degree corresponding to the training battery is extracted from the target training battery data through the use time feature extraction model to obtain the use time feature. The seventh proportion of the charging pressure difference in the first preset pressure difference range and the eighth proportion of the charging pressure difference in the second preset pressure difference range are extracted from the target training battery data through the charging pressure difference feature extraction model to obtain the charging pressure difference feature. For example, the first preset pressure difference range may be 0-100mV, or 10-90mV The second preset voltage difference range may be 100-300mV, or 120-280mV. The ninth proportion of the discharge voltage difference in the third preset voltage difference range and the tenth proportion of the discharge voltage difference in the fourth preset voltage difference range are extracted from the target training battery data through the discharge voltage difference feature extraction model to obtain the discharge voltage difference feature. For example, the third preset pressure difference range may be 0-100mV, or 10-90mV The fourth preset pressure difference range may be 100-300mV, or 120-280mV. The use time feature, the charging voltage difference feature and the discharge voltage difference feature are spliced into the battery performance feature.

Operation A30, performing normalization processing on the training vehicle-using behavior feature to obtain normalized vehicle-using behavior feature.

In this embodiment, the normalization processing is performed on the accumulation feature in the training vehicle-using behavior feature, and the accumulation feature is mapped to the normalized accumulation feature of the preset value range. The normalized accumulation feature and the proportion feature are spliced into the normalized vehicle-using behavior feature. The preset value range is 0-1.

As a feasible embodiment, in the above operation A30, the operation of performing the normalization processing on the training vehicle-using behavior feature to obtain the normalized vehicle-using behavior feature may include:

obtaining a preset feature threshold corresponding to each vehicle-using behavior feature; and
obtaining the normalized vehicle-using behavior feature according to a ratio of each vehicle-using behavior feature to the preset feature threshold.

It can be understood that the value range of the proportion feature is 0-1, so there is no need to process the proportion feature.

In this embodiment, the method includes: obtaining the preset feature threshold corresponding to each accumulation feature in the training vehicle-using behavior feature; using a ratio of each accumulation feature to the preset feature threshold as a normalized accumulation feature; and splicing the normalized accumulation feature and the proportion feature into the normalized vehicle-using behavior feature.

In an embodiment, when the accumulation feature is the mileage feature, the preset mileage threshold corresponding to the mileage feature is obtained, and a first ratio between the mileage feature and the preset mileage threshold is used as the normalized mileage feature corresponding to the mileage feature. The preset mileage threshold can be 700,000km or 650,000km. When the accumulation feature is the full discharge times feature, the preset full discharge times threshold corresponding to the full discharges times feature is obtained. The preset full discharge times threshold is obtained by a second ratio of the preset mileage threshold and the estimated mileage of the preset remaining power range during the discharging process. The preset remaining power range can be 0-100 or 10-90. The estimated mileage can be 370km or 350km. The fourth ratio between the full discharge times feature and the preset full discharge times threshold is used as the normalized full discharge times feature corresponding to the full discharge times feature. When the accumulation feature is the discharge duration feature, the preset discharge duration threshold corresponding to the discharge duration feature is obtained. The preset discharge duration threshold is obtained by the fourth ratio of the mileage threshold to the estimated average driving speed. The estimated average driving speed can be 30km/h or 35km/h. The fifth ratio between the discharge duration feature and the preset discharge duration threshold is preset as the normalized discharge duration feature corresponding to the discharge duration feature. When the accumulation feature is the usage time feature, the preset usage time threshold corresponding to the usage time feature is obtained. The sixth ratio of the usage time feature to the preset usage time threshold is used as the normalized usage time feature corresponding to the usage time feature. The preset usage time threshold can be 7200 days or 9000 days.

By normalizing the training vehicle-using behavior feature to eliminate the impact of the battery pack characteristics of different batteries on the health, the battery health state prediction model obtained through training can be transferred between different battery packs, thereby reducing the prediction limitation of the battery health state prediction model.

Operation A40, predicting and obtaining a training health degree of the battery according to the normalized vehicle-using behavior feature and the battery health state prediction model to be trained.

In this embodiment, the normalized vehicle-using behavior feature is mapped to the training health degree of the battery through the battery health state prediction model to be trained.

Operation A50, iteratively optimizing the battery health state prediction model to be trained to obtain the battery health state prediction model according to the training health degree and the real health degree.

In this embodiment, the model loss corresponding to the battery health prediction model to be trained is calculated according to the difference between the training health degree and the real health degree, and then it is determined that whether the model loss is converged. If the model loss converges, the battery health prediction model to be trained is used as the battery health prediction model. If the model loss does not converge, based on the gradient calculated by the model loss, the battery health prediction model to be trained is updated through the preset model update method. The preset model update method is a gradient descent method, a gradient ascent method, and the like.

The battery health feature data is extracted from the training sample data. The battery health feature data is used to characterize the health state of the training battery. The health state of the training battery is predicted by presetting the health degree prediction model and the battery health feature data to obtain the real health degree. The battery health feature data includes but not limited to current feature and battery capacity feature.

The health degree of the battery is predicted through the preset health degree prediction model, and the battery health feature data is mapped to the health value of the battery. There is no concrete representation for the health degree of the battery. By predicting the health degree of the battery only through the battery health feature data and the preset health degree prediction model, it is prone to inaccurate prediction of the health state of the battery due to fewer features selected to characterize the health state of the battery, which in turn leads to inaccurate acquisition of the real health degree of the training battery.

As a feasible embodiment, in the above operation A10, the calculating the real health degree of the battery based on the training sample data may include:

Operation A11, selecting battery charging data satisfying a preset charging working condition from the training sample data, wherein the battery charging data includes a training battery current of the battery during a charging process, a first remaining power of the training battery to start the charging process, a second remaining power of the training battery after the charging process and a rated battery capacity of the battery; and

Operation A12, determining the real health degree of the battery according to the training battery current, the first remaining power, the second remaining power and the rated battery capacity.

It should be noted that, in this embodiment, the remaining power is the discharge SOC (State of Charge, also called the remaining power). The rated battery capacity is the capacity that the battery can continue to work for a long time under the rated working conditions, which is determined by the properties of the battery. The preset charging working condition is a preset charging working condition for determining that the charging working condition of the battery is ideal.

In this embodiment, when the preset charging condition is selected from the training sample data, according to the training battery current during the charging process, the first remaining power at the beginning of the charging process, the second remaining power at the end of the charging process, and the rated battery capacity, the battery charging data is obtained. The difference between the second remaining power and the first remaining power is obtained, and the real health degree corresponding to the training battery is obtained according to a ratio of the training battery current to a product of the difference and the rated battery capacity.

In an embodiment, determining the real health degree corresponding to the battery according to the training battery current, the first remaining power, the second remaining power and the rated battery capacity

may be

$$SOH = \frac{\int_{t_\alpha}^{t_\beta} I d_t}{(SOC_\beta - SOC_\alpha) * Q_{额}}$$

SOH is the real health degree corresponding to the battery, $t\beta$ is the time when the charging process of the battery ends, $t\alpha$ is the time when the charging process of the battery starts; $SOC\alpha$ is the first remaining power; $SOC\beta$ is the second remaining power; $Q_{rated}$ is the rated battery capacity.

According to the battery current, the remaining power and the rated battery capacity, the health degree of the battery under ideal charging conditions is calculated, and the health state of the battery is accurately determined in a quantitative manner. Therefore, the determination accuracy of the health state of the battery is improved, thereby improving the determination accuracy of the real health degree of the battery.

As a feasible embodiment, in the above operation A11, the operation of selecting the battery charging data satisfying the preset charging working condition from the training sample data may include:

selecting a first battery data from the training sample data, wherein the first battery data is battery data whose resting duration after the charging process is completed is longer than a preset duration threshold; and

determining that a second battery data in the first battery data is the battery charging data, wherein the second battery data is battery data in which a difference between the second remaining power and the first remaining power is greater than a preset power threshold and a current at the end of the charging process is less than a preset current threshold.

It should be noted that, in this embodiment, the preset duration threshold is the preset critical value of the resting duration that determines that the authenticity of the battery voltage value measurement is less affected after the charging is completed. The preset duration threshold may be 30 minutes or 35 minutes. The preset power threshold is a preset critical value of the difference between the second remaining power and the first remaining power that has little influence on the calculation of the real health of the training battery. The preset power threshold can be 50 or 55. The preset current threshold is a preset current critical value that has little influence on the calculation of the remaining power of the training battery. The preset current threshold can be 1C or 0.8C.

In this embodiment, the resting duration of each training sample data after the charging process ends is obtained, and the first battery data whose resting duration is greater than the preset time length threshold in each training battery data is selected. The first remaining power at the beginning of the charging process, the current at the end of the charging process, and the second remaining power at the end of the charging process of the first battery data are obtained. The second battery data whose difference between the second remaining power and the first remaining power is greater than a preset power threshold and whose current is less than a preset current threshold is selected from the first battery data as the battery charging data.

It can be understood that when the current of the battery during the charging process is too large, it is easy to have a deviation between the calculated battery voltage and the actual battery voltage, resulting in inaccurate remaining residual voltage, which in turn leads to low accuracy of the calculated real health degree of the battery. When the difference between the second remaining power and the first remaining power is small, errors are likely to be relatively large, resulting in low accuracy of the calculated real health degree of the battery. When the resting duration of the battery after the charging process is completed is too short, the polarization internal resistance of the battery is relatively large, it is easy to cause a deviation between the calculated battery voltage and the actual battery voltage, resulting in an inaccurate calculated remaining voltage, which in turn leads to low accuracy of the calculated real health degree of the battery.

In this embodiment, the battery charging data meeting the preset charging condition is selected. The preset charging conditions include conditions for constraining the difference between the second remaining power and the first remaining power of the battery during the charging process, the resting duration of the battery after the charging process ends, and the current at the end of the charging process. Therefore, the low accuracy of the calculated real health degree of the battery caused by the excessive current of the battery during the charging process and/or a small difference between the second remaining power and the first remaining power and/or the short resting duration of the battery after the charging process ends is avoided, thereby improving the determination accuracy of the real health degree of the battery.

Besides, the embodiments of the present application further provide a vehicle as mentioned in any one of the above embodiments.

As shown in FIG. 11, FIG. 11 is a schematic structural diagram of the device in the hardware operating environment of the method for predicting the state of health of the battery of the present application.

As shown in FIG. 11, the vehicle may include a processor 1001, such as a CPU, a communication bus 1002, a network interface 1003, and a memory 1004. The communication bus 1002 is used to realize the communication between the processor 1001 and the memory 1004. The memory 1004 may be a high-speed random access memory (RAM), or a stable memory (non-volatile memory), such as a disk memory. The memory 1004 may also be a storage device independent of the aforementioned processor 1001.

The vehicle may also include a graphical user interface, a network interface, a camera, a radio frequency (RF) circuit, a sensor, an audio circuit, a WiFi module, and the like. The graphical user interface may include a display, an input sub-module such as a keyboard. The graphical user interface may also include standard wired interfaces and wireless interfaces. The network interface may include a standard wired interface and a wireless interface (such as a WI-FI interface).

Those skilled in the art can understand that the structure shown in FIG. 11 does not constitute a limitation on the vehicle, based on different design requirements of actual applications, in different possible embodiments, the vehicle may also include more or fewer components than shown, or a combination of components, or differently arranged components.

As shown in FIG. 11, the memory 1004 as a storage medium may include an operating system, a network communication module, and a battery health state prediction program. The operating system is a program that manages and controls resources based on vehicle hardware and software, and supports the operation of the battery health state prediction program and other software and/or programs. The network communication module is used to realize the communication among the various components inside the memory 1004, as well as communicate with other hardware and software in the battery health state prediction system.

In the vehicle shown in FIG. 11, the processor 1001 is configured to execute the battery health state prediction program stored in the memory 1004 to implement the operations of the method for predicting state of health of the battery described in any one of the above embodiments.

The present application is basically the same as the embodiments of the method for predicting the state of health of the battery based on the specific implementation of the vehicle, and will not be repeated herein.

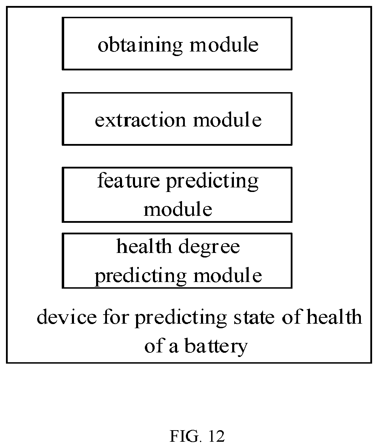

Besides, the present application further provides a device for predicting state of health (SOH) of a battery. The device for predicting the state of health of the battery of the present application is applied to the vehicle to control the prediction of the battery health state, as shown in FIG. 12, the device for predicting the state of health of the battery includes:

an obtaining module for obtaining battery data of a vehicle;
an extraction module for performing feature extraction on the battery data to obtain a vehicle-using behavior feature corresponding to the vehicle;
a feature predicting module for predicting and obtaining a predicted vehicle-using behavior feature of the vehicle in a next time step according to the vehicle-using behavior feature; and

a health degree predicting module for predicting and obtaining a health degree of the battery in the vehicle according to the predicted vehicle-using behavior feature and a battery health state prediction model.

In an embodiment, a feature type of the vehicle-using behavior feature includes a proportion feature and an accumulation feature, and the feature predicting module is further configured for predicting and obtaining a predicted accumulation feature of the vehicle in the next time step according to a preset linear fitting model and the vehicle-using behavior feature; and aggregating the proportion feature and the accumulation feature to obtain the predicted vehicle-using behavior feature of the vehicle in the next time step.

In an embodiment, before the predicting and obtaining the health degree of the battery in the vehicle according to the predicted vehicle-using behavior feature and the battery health state prediction model, the device is further configured for:

obtaining a battery health state prediction model to be trained and training sample data of the battery in the vehicle, and calculating a real health degree of the battery based on the training sample data;

performing feature extraction on the training sample data to obtain a training vehicle-using behavior feature corresponding to the battery;

performing normalization processing on the training vehicle-using behavior feature to obtain normalized vehicle-using behavior feature;

predicting and obtaining a training health degree of the battery according to the normalized vehicle-using behavior feature and the battery health state prediction model to be trained; and

iteratively optimizing the battery health state prediction model to be trained to obtain the battery health state prediction model according to the training health degree and the real health degree.

In an embodiment, a feature content of the training vehicle-using behavior feature includes a user behavior feature and a battery performance feature, and the device for predicting the state of health of the battery is further configured for:

obtaining a cut-off time of battery charging data for calculating the real health degree in the training battery data;

selecting training battery data satisfying a preset health state prediction condition before the cut-off time from the training sample data; and

extracting the user behavior feature and the battery performance feature according to the training battery data.

In an embodiment, the device for predicting the state of health of the battery is further configured for:

selecting battery charging data satisfying a preset charging working condition from the training sample data, wherein the battery charging data includes a training battery current of the battery during a charging process, a first remaining power of the training battery to start the charging process, a second remaining power of the training battery after the charging process and a rated battery capacity of the battery; and

determining the real health degree of the battery according to the training battery current, the first remaining power, the second remaining power and the rated battery capacity.

In an embodiment, the device for predicting the state of health of the battery is further configured for:

selecting a first battery data from the training sample data, wherein the first battery data is battery data whose resting duration after the charging process is completed is longer than a preset duration threshold; and

determining that a second battery data in the first battery data is the battery charging data, wherein the second battery data is battery data in which a difference between the second remaining power and the first remaining power is greater than a preset power threshold and a current at the end of the charging process is less than a preset current threshold.

In an embodiment, the device for predicting the state of health of the battery is further configured for:

obtaining a preset feature threshold corresponding to each training vehicle-using behavior feature; and

obtaining the normalized vehicle-using behavior feature according to a ratio of each training vehicle-using behavior feature to the preset feature threshold.

The specific implementation of each functional module of the device for predicting the state of health of the battery of the present application is basically the same as the embodiments of the method for predicting the state of health of the battery as described above, and will not be repeated here.

Embodiments of the present application provide a computer storage medium, and the computer storage medium stores one or more programs. The one or more programs can also be executed by one or more processors to implement the method for predicting the state of health of the battery as described above.

The specific implementation of the computer storage medium in the present application is basically the same as the embodiments of the method for predicting the state of health of the battery, and will not be repeated here.

The present application also provides a computer program product, including a computer program.

When the computer program is executed by a processor, the operations of the method for predicting the state of health of the battery as described above are realized.

The specific implementation manners of the computer program product of the present application are basically the same as the embodiments of the method for predicting the state of health of the battery as described above, and will not be repeated here.

It should be noted that in this document, the terms "comprise", "include" or any other variants thereof are intended to cover a non-exclusive inclusion. Thus, a process, method, article, or system that includes a series of elements not only includes those elements, but also includes other elements that are not explicitly listed, or also includes elements inherent to the process, method, article, or system. If there are no more restrictions, the element defined by the sentence "including a..." does not exclude the existence of other identical elements in the process, method, article or system that includes the element.

The serial numbers of the foregoing embodiments of the present application are only for description, and do not represent the advantages and disadvantages of the embodiments.

Through the description of the above embodiment, those skilled in the art can clearly understand that the above-mentioned embodiments can be implemented by software plus a necessary general hardware platform, of course, it can also be implemented by hardware, but in many cases the former is a better implementation. Based on this understanding, the technical solution of the present application can be embodied in the form of software product in essence or the part that contributes to the existing technology. The computer software product is stored on a storage medium (such as ROM/RAM, magnetic disk, optical disk) as described above, including several instructions to cause a terminal device (which can be a car computer, a smart phone, a computer, a server, an air conditioner, or a network device, etc.) to execute the method described in each embodiment of the present application.

The above are only some embodiments of the present application, and do not limit the scope of the present application thereto. Under the concept of the present application, equivalent structural transformations made according to the description and drawings of the present application, or direct/indirect application in other related technical fields are included in the scope of the present application.

**Claims**

1. A method for predicting state of health of a battery **characterized by** comprising:

   (S10), obtaining battery data of a vehicle;
   (S20), performing feature extraction on the battery data to obtain a vehicle-using behavior feature corresponding to the vehicle;
   (S30), predicting and obtaining a predicted vehicle-using behavior feature of the vehicle in a next time step according to the vehicle-using behavior feature; and
   (S40), predicting and obtaining a health degree of the battery in the vehicle according to the predicted vehicle-using behavior feature and a battery health state prediction model.

2. The method according to claim 1, wherein a feature type of the vehicle-using behavior feature comprises a proportion feature and an accumulation feature, and the predicting and obtaining the predicted vehicle-using behavior feature of the vehicle in the next time step according to the vehicle-using behavior feature comprises:

   predicting and obtaining a predicted accumulation feature of the vehicle in the next time step according to a preset linear fitting model and the vehicle-using behavior feature; and
   aggregating the proportion feature and the accumulation feature to obtain the predicted vehicle-using behavior feature of the vehicle in the next time step.

3. The method according to claim 1, wherein before the predicting and obtaining the health degree of the battery in the vehicle according to the predicted vehicle-using behavior feature and the battery health state prediction model, the method further comprises:

   obtaining a battery health state prediction model to be trained and training sample data of the battery in the vehicle, and calculating a real health degree of the battery based on the training sample data;
   performing feature extraction on the training sample data to obtain a training vehicle-using behavior feature corresponding to the battery;
   performing normalization processing on the training vehicle-using behavior feature to obtain normalized vehicle-using behavior feature;
   predicting and obtaining a training health degree of the battery according to the normalized vehicle-using behavior feature and the battery health state prediction model to be trained; and
   iteratively optimizing the battery health state prediction model to be trained to obtain the battery health state prediction model according to the training health degree and the real health degree.

4. The method according to claim 3, wherein a feature content of the training vehicle-using behavior feature comprises a user behavior feature and a battery performance feature, and the performing the feature extraction on the training sample data to obtain the training vehicle-using behavior feature corresponding to the battery comprises:

obtaining a cut-off time of battery charging data for calculating the real health degree in the training battery data;
selecting training battery data satisfying a preset health state prediction condition before the cut-off time from the training sample data; and
extracting the user behavior feature and the battery performance feature according to the training battery data.

5. The method according to claim 3, wherein the calculating the real health degree of the battery based on the training sample data comprises:

selecting battery charging data satisfying a preset charging working condition from the training sample data, wherein the battery charging data comprises a training battery current of the battery during a charging process, a first remaining power of the training battery to start the charging process, a second remaining power of the training battery after the charging process and a rated battery capacity of the battery; and
determining the real health degree of the battery according to the training battery current, the first remaining power, the second remaining power and the rated battery capacity.

6. The method according to claim 5, wherein the selecting the battery charging data satisfying the preset charging working condition from the training sample data comprises:

selecting a first battery data from the training sample data, wherein the first battery data is battery data whose resting duration after the charging process is completed is longer than a preset duration threshold; and
determining that a second battery data in the first battery data is the battery charging data, wherein the second battery data is battery data in which a difference between the second remaining power and the first remaining power is greater than a preset power threshold and a current at the end of the charging process is less than a preset current threshold.

7. The method according to claim 3, wherein the performing the normalization processing on the training vehicle-using behavior feature to obtain the normalized vehicle-using behavior feature comprises:

obtaining a preset feature threshold corresponding to each training vehicle-using behavior feature; and
obtaining the normalized vehicle-using behavior feature according to a ratio of each training vehicle-using behavior feature to the preset feature threshold.

8. A device for predicting state of health of a battery **characterized by** comprising:

an obtaining module for obtaining battery data of a vehicle;
an extraction module for performing feature extraction on the battery data to obtain a vehicle-using behavior feature corresponding to the vehicle;
a feature predicting module for predicting and obtaining a predicted vehicle-using behavior feature of the vehicle in a next time step according to the vehicle-using behavior feature; and
a health degree predicting module for predicting and obtaining a health degree of the battery in the vehicle according to the predicted vehicle-using behavior feature and a battery health state prediction model.

9. An electronic equipment **characterized by** comprising:

at least one processor (1001); and
a memory (1004) communicated with the at least one processor (1001),
wherein the memory (1004) stores instructions executable by the at least one processor (1001), and when the instructions are executed by the at least one processor (1001), the at least one processor (1001) implements the method for predicting the state of health of the battery according to any one of claims 1 to 7.

10. A computer-readable storage medium **characterized by** the fact that computer-readable storage medium stores a program for realizing a method for predicting state of health of a battery, and when the program for realizing the method for predicting the state of health of the battery is executed by a processor (1001), the method for predicting the state of health of the battery according to any one of claims 1 to 7 is implemented.

```
                                                                    ┌── S10
┌─────────────────────────────────────────────────────────────────┐
│                    obtaining battery data of a vehicle            │
└─────────────────────────────────────────────────────────────────┘
                                │
                                ▼                                   ┌── S20
┌─────────────────────────────────────────────────────────────────┐
│ performing feature extraction on the battery data to obtain a vehicle-using behavior feature │
│                    corresponding to the vehicle                   │
└─────────────────────────────────────────────────────────────────┘
                                │
                                ▼                                   ┌── S30
┌─────────────────────────────────────────────────────────────────┐
│ predicting and obtaining a predicted vehicle-using behavior feature of the vehicle in a next │
│          time step according to the vehicle-using behavior feature │
└─────────────────────────────────────────────────────────────────┘
                                │
                                ▼                                   ┌── S40
┌─────────────────────────────────────────────────────────────────┐
│ predicting and obtaining a health degree of the battery in the vehicle according to the │
│   predicted vehicle-using behavior feature and a battery health state prediction model │
└─────────────────────────────────────────────────────────────────┘
```

FIG. 1

trend of vehicle mileage over time

FIG. 2

fitting and prediction of vehicle mileage

FIG. 3

| vehicle type | VIN | total mileage | full discharge circles | discharge duration | calendar life of the vehicle | proportion of charging current 0-50A | proportion of SOC at 90-100 at the end of charging | ...... |
|---|---|---|---|---|---|---|---|---|
| B | VVVVVB5 | 193,000 kilometers | 561 | 7546.7h | 1084day | 0.25 | 0.83 | ...... |
| B | VVVVVB5 | 217,000 kilometers | 630.8 | 8486.5h | 1104day | 0.25 | 0.83 | |

The other four features are predicted with a linear fit

Proportional features continue the original value

FIG. 4

| 14 feature values | | trained random forest model | | output SOH result |
|---|---|---|---|---|

FIG. 5

FIG. 6

FIG. 7

FIG. 8

| vehicle type | VIN | estimated maximum mileage | estimated maximum calendar life | total mileage of the vehicle | full discharge circles of the vehicle | discharge duration of the vehicle | calendar life of the vehicle |
|---|---|---|---|---|---|---|---|
| A | VVVVVA1 | 700,000 kilometers | 20 years | 61,000 kilometers | 199.5 | 2125.6h | 1823.6day |
| B | VVVVVB2 | 800,000 kilometers | 25 years | 33,000 kilometers | 77.3 | 1363.8h | 1237.5day |
| ... | ... | ... | ... | ... | ... | ... | ... |

| vehicle type | VIN | total mileage | full discharge circles | discharge duration | calendar life of the vehicle | proportion of charging current 0-50A | proportion of SOC at 90- ······ 100 at the end of charging | ······ |
|---|---|---|---|---|---|---|---|---|
| B | VVVVB5 | 193,000 kilometers | 561 | 7546.7h | 1084day | 0.25 | 0.83 | |

FIG. 9

| VIN | date | cut off mileage | total SOC depth | total discharge duration |
|---|---|---|---|---|
| VVVVVB5 | 2019/06/06 | 11. 8 | 3. 3 | 0. 15 |
| VVVVVB5 | 2019/06/07 | 13. 8 | 3. 5 | 0. 23 |
| VVVVVB5 | 2019/06/08 | 14. 6 | 5. 1 | 1. 72 |
| ...... | ...... | ...... | ...... | ...... |

FIG. 10

FIG. 11

obtaining module

extraction module

feature predicting module

health degree predicting module

device for predicting state of health of a battery

FIG. 12

Europäisches
Patentamt

European
Patent Office

Office européen
des brevets

# EUROPEAN SEARCH REPORT

Application Number

EP 23 18 6995

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/247447 A1 (DESAI SAURABH JAYWANT [IN] ET AL) 12 August 2021 (2021-08-12) <br> * figures 1-5 * <br> * paragraphs [0020] - [0052] * <br> ----- | 1-10 | INV. <br> B60L58/16 <br> G01R31/382 <br> G01R31/392 |
| X | CN 112 666 464 A (BEIJING DIDI INFINITY TECHNOLOGY & DEV CO LTD) 16 April 2021 (2021-04-16) <br> * figures 1-10 * <br> * paragraphs [0041] - [0100] * <br> ----- | 1-10 | |
| A | CN 111 965 558 A (BAONENG GUANGZHOU AUTOMOBILE RES INST CO LTD) 20 November 2020 (2020-11-20) <br> * figures 1-3 * <br> * paragraphs [0018] - [0030] * <br> ----- | 1-10 | |

TECHNICAL FIELDS
SEARCHED    (IPC)

B60L
G01R

The present search report has been drawn up for all claims

| Place of search | Date of completion of the search | Examiner |
|---|---|---|
| The Hague | 22 November 2023 | Gücin, Taha |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
....................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 6995

22-11-2023

| Patent document cited in search report | | Publication date | Patent family member(s) | | Publication date |
|---|---|---|---|---|---|
| US 2021247447 | A1 | 12-08-2021 | EP | 3845918 A1 | 07-07-2021 |
| | | | US | 2021247447 A1 | 12-08-2021 |
| CN 112666464 | A | 16-04-2021 | CN | 112666464 A | 16-04-2021 |
| | | | WO | 2022161002 A1 | 04-08-2022 |
| CN 111965558 | A | 20-11-2020 | NONE | | |

EPO FORM P0459